(19) Europäisches Patentamt / European Patent Office / Office européen des brevets

(11) **EP 2 639 960 A1**

(12) **DEMANDE DE BREVET EUROPEEN**

(43) Date de publication:
**18.09.2013 Bulletin 2013/38**

(51) Int Cl.:
**H03K 17/10** (2006.01)  **H03K 17/14** (2006.01)
**H02M 7/00** (2006.01)  **H02M 1/088** (2006.01)

(21) Numéro de dépôt: **13159545.6**

(22) Date de dépôt: **15.03.2013**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **16.03.2012  FR 1252392**

(71) Demandeur: **GE Energy Power Conversion
Technology Ltd
Rugby
Warwickshire CV21 1BU (GB)**

(72) Inventeurs:
• **Richard, Stéphane
  93700 DRANCY (FR)**
• **Cara, Hervé
  78117 TOUSSUS LE NOBLE (FR)**
• **Nicolai, Jean-Marc
  92400 COURBEVOIE (FR)**

(74) Mandataire: **Blot, Philippe Robert Emile et al
Cabinet Lavoix
2, place d'Estienne d'Orves
75441 Paris Cedex 09 (FR)**

(54) **Procédé de compensation des tolérances de fabrication d'au moins un paramètre électrique d'un transistor de puissance et système associé**

(57)  La présente invention concerne un système (21) comportant :
- un transistor de puissance (22),
- un support de données (60) comprenant des données relatives à la tolérance de fabrication (Tol) d'au moins un paramètre électrique du transistor (22),
- un circuit électrique (26) de commande du transistor adapté à fonctionner pour une valeur de référence du paramètre ($V_{REF}$),
- un circuit électrique (64) ayant une inductance inférieure à 100 nH et tel que l'ensemble (70) formé par le circuit (64) et le transistor (22) a une valeur pour le paramètre dont l'écart en valeur absolue avec la valeur de référence est strictement inférieur à la tolérance de fabrication (Tol).

FIG.2

EP 2 639 960 A1

## Description

La présente invention concerne un procédé de compensation des tolérances de fabrication d'au moins un paramètre électrique d'un transistor de puissance ainsi que le système associé.

Les moteurs à courant alternatif sont couramment alimentés à partir d'un bus d'alimentation en courant continu aux bords desquels sont connectées les différentes phases des moteurs par l'intermédiaire d'un variateur de fréquence, constitué d'organes de commutation dont l'état est piloté par une électronique de commande adaptée.

De telles électroniques de commande sont par exemple discutées dans les documents EP-A-0 458 511 et DE-A-141 35 26.

Pour les moteurs d'entraînement de pompes ou de compresseurs très puissants, notamment pour l'exploitation pétrolière, de très fortes puissances électriques peuvent circuler au travers des organes de commutation assurant l'alimentation du moteur. A titre d'exemple, des tensions comprises entre 1000 et 4000 Volts peuvent être appliquées sur les organes de commutation.

Les organes de commutation sont constitués par les transistors de type bipolaire à grille isolée. Le transistor bipolaire à grille isolée, dont l'acronyme anglais est IGBT pour insulated gate bipolar transistor, est un dispositif semi-conducteur de la famille des transistors qui est utilisé comme interrupteur électronique, principalement dans les montages d'électronique de puissance. Ce composant, qui combine les avantages d'une grande simplicité de commande du transistor à effet de champ par rapport au transistor bipolaire tout en conservant les faibles pertes par combustion de ce dernier, a permis de nombreux progrès dans l'électronique de puissance aussi bien en ce qui concerne la fiabilité que l'aspect économique. Néanmoins, pour faire des variateurs de fréquences de moteurs très puissants, il convient de monter en série une pluralité de transistors de type transistors IGBT pour assurer chaque commutation, un unique transistor ne permettant pas d'interrompre la circulation du courant pour des tensions très élevées à ses bornes.

La pluralité de transistors ainsi connectée en série doit être commandée avec une synchronisation parfaite afin que les transistors correspondent fonctionnellement à un unique transistor. Les erreurs de synchronisation entre les différents transistors conduisent à ce que la tension soit supportée par seulement un des transistors, ce qui peut occasionner sa destruction.

Compte tenu des tolérances de fabrication des transistors et de la précision de l'électronique de commande, la synchronisation du fonctionnement des transistors est délicate à assurer. Les solutions électroniques de commande très sophistiquées ont été ainsi développées. De telles solutions impliquent la mise en oeuvre de circuits intégrés spécifiques qui sont très coûteux.

Il est également connu une technique de protection des transistors désignés couramment en anglais par l'expression « active clamping ». Suivant cette solution, les transistors sont associés entre la grille de commande et une borne de conduction à une diode zéner avec une résistance qui, lorsque la tension est trop forte entre les bornes de conduction du transistor permet de ramener le transistor vers son état passant et ainsi limiter la tension à ses bornes.

Cette technique impose des marges d'allumage de transistors très élevées et impose l'utilisation de diodes zéner résistantes et relativement précises.

Le document WO-A-2007/122 322 décrit aussi un procédé d'équilibrage des tensions de deux transistors IGBT placés en série utilisant une méthode dite d' « active sharing » (notion de maître/esclave).

Ces différentes solutions s'avèrent adaptées pour un nombre limité de transistors IGBT, tels deux ou trois. Cependant, lorsqu'un nombre important de transistors IGBT est considéré pour la mise en série, typiquement quatre, ces solutions ne sont plus adaptées, notamment parce que le réglage proposé est dépendant à la fois du transistor et du circuit de commande considéré. En cas de remplacement suite à un dysfonctionnement d'un des deux éléments, c'est l'ensemble du réglage qui est à reprendre.

Il existe donc un besoin pour un circuit permettant de faciliter la maintenance des systèmes dans lesquels des transistors de puissance, en particulier des transistors IGBT, sont déclenchés simultanément, notamment dans une configuration série.

Pour cela, il est proposé un système comportant un transistor de puissance, un support de données comprenant des données relatives à la tolérance de fabrication d'au moins un paramètre électrique du transistor et un circuit électrique de commande du transistor adapté à fonctionner pour une valeur de référence du paramètre. Le système comporte un circuit électrique ayant une inductance inférieure à 100 nH et tel que l'ensemble formé par le circuit et le transistor a une valeur pour le paramètre dont l'écart en valeur absolue avec la valeur de référence est strictement inférieur à la tolérance de fabrication.

Il est également proposé un dispositif comportant un premier transistor de puissance obtenu par un procédé de fabrication et présentant une première valeur pour un paramètre électrique du transistor et un deuxième transistor de puissance obtenu par le même procédé de fabrication présentant une deuxième valeur pour le paramètre, la deuxième valeur étant différente de la première valeur. Le dispositif comporte aussi un premier circuit tel que le premier ensemble formé par le premier circuit et le premier transistor présente une troisième valeur pour le paramètre et un deuxième circuit tel que le deuxième ensemble formé par le deuxième circuit et le deuxième transistor présente une quatrième valeur pour le paramètre, l'écart en valeur absolue entre la troisième et la quatrième valeur étant strictement inférieur à l'écart en valeur absolue entre la première et la deuxième valeur.

Suivant des modes de réalisation particuliers, le système ou le dispositif comprend une ou plusieurs des caractéristiques suivantes, prise(s) isolément ou suivant toutes les combinaisons techniquement possibles :

- le support de données est une notice du transistor.
- le paramètre électrique est relatif à la commutation du transistor.
- le paramètre électrique est l'un des paramètres suivants : la capacité Miller, la tension de seuil du transistor, le temps de retard du transistor et le temps de montée du transistor.
- le ou les circuits électriques ont une inductance inférieure à 75 nH.
- le ou les circuits électriques comportent des composants passifs.
- le ou les circuits électriques comportent des composants actifs.
- le ou les circuits électriques sont un circuit souple.
- le ou les circuits électriques et le circuit de commande sont confondus.
- le système ou le dispositif est destiné au déclenchement simultané de transistor de puissance.

Il est également proposé un ensemble comportant plusieurs systèmes tels que précédemment décrit, les circuits électriques de commandes étant les mêmes pour chaque transistor des systèmes.

L'invention concerne aussi une alimentation électrique comportant l'ensemble précédemment décrit.

Il est aussi proposé un procédé de compensation de tolérances de fabrication d'au moins un paramètre électrique d'un transistor de puissance, le procédé comportant les étapes fourniture d'un transistor de puissance et de fourniture de données relatives à la tolérance de fabrication d'un ou de paramètre électrique du transistor. Le procédé comporte une étape de fourniture d'une valeur de référence pour le paramètre et de fourniture d'un circuit électrique ayant une inductance inférieure à 100 nH et tel que l'ensemble formé par le circuit et le transistor a une valeur pour le paramètre dont l'écart en valeur absolue avec la valeur de référence est strictement inférieur à la tolérance de fabrication.

En d'autres termes, l'invention concerne un dispositif comportant un premier transistor de puissance obtenu par un procédé de fabrication et présentant une première valeur pour un paramètre électrique du transistor, un deuxième transistor de puissance obtenu par le même procédé de fabrication présentant une deuxième valeur pour le paramètre, la deuxième valeur étant différente de la première valeur, un premier circuit électrique tel que le premier ensemble formé par le premier circuit électrique et le premier transistor présente une troisième valeur pour le paramètre, et un deuxième circuit électrique tel que le deuxième ensemble formé par le deuxième circuit électrique et le deuxième transistor présente une quatrième valeur pour le paramètre. L'écart en valeur absolue entre la troisième valeur et la quatrième valeur est strictement inférieur à l'écart en valeur absolue entre la première valeur et la deuxième valeur. Le premier circuit électrique présente une inductance inférieure à 100 nH, est un circuit souple, et comporte des composants passifs ou actifs. Le deuxième circuit électrique présente une inductance inférieure à 100 nH, est un circuit souple, et comporte des composants passifs ou actifs.

Suivant des modes de réalisation particuliers, le dispositif comprend une ou plusieurs des caractéristiques suivantes, prise(s) isolément ou suivant toutes les combinaisons techniquement possibles :

- le paramètre électrique est relatif à la commutation des transistors.
- le paramètre électrique est l'un des paramètres suivants : la capacité Miller, la tension de seuil des transistors, le temps de retard des transistors et le temps de montée des transistors.
- au moins l'un du premier circuit électrique et du deuxième circuit électrique présente une inductance inférieure à 75 nH.

L'invention se rapporte également à un système comportant un transistor de puissance, un support de données comprenant des données relatives à la tolérance de fabrication d'au moins un paramètre électrique du transistor, et un circuit électrique de commande du transistor adapté à fonctionner pour une valeur de référence du paramètre. Le système comporte, en outre, un circuit électrique présentant une inductance inférieure à 100 nH, étant un circuit souple, comportant des composants passifs ou actifs, et tel que l'ensemble formé par le circuit électrique et le transistor a une valeur pour le paramètre électrique dont l'écart en valeur absolue avec la valeur de référence est strictement inférieur à la tolérance de fabrication.

Suivant des modes de réalisation particuliers, le système comprend une ou plusieurs des caractéristiques suivantes, prise(s) isolément ou suivant toutes les combinaisons techniquement possibles :

- le support de données est une notice du transistor.
- le circuit électrique et le circuit électrique de commande sont confondus.
- le paramètre électrique est relatif à la commutation du transistor.
- le paramètre électrique est l'un des paramètres suivants : la capacité Miller, la tension de seuil du transistor, le temps de retard du transistor et le temps de montée du transistor.
- le circuit électrique a présente une inductance inférieure à 75 nH.
- le système étant destiné au déclenchement simultané de transistors de puissance.

Il est également proposé un ensemble comportant plusieurs systèmes tels que précédemment décrits. Les circuits électriques de commande sont les mêmes pour chaque transistor des systèmes.

L'invention concerne aussi l'alimentation électrique comportant l'ensemble tel que précédemment décrit.

Il est aussi proposé un procédé de compensation de tolérances de fabrication d'au moins un paramètre électrique d'un transistor de puissance, le procédé comportant les étapes de fourniture d'un transistor de puissance, de fourniture de données relatives à la tolérance de fabrication d'au moins un paramètre électrique du transistor, de fourniture d'une valeur de référence pour le paramètre électrique et de fourniture d'un circuit électrique présentant une inductance inférieure à 100 nH, le circuit électrique étant un circuit souple, comportant des composants passifs ou actifs, et tel que l'ensemble formé par le circuit électrique et le transistor a une valeur pour le paramètre dont l'écart en valeur absolue avec la valeur de référence est strictement inférieur à la tolérance de fabrication.

D'autres caractéristiques et avantages de l'invention apparaîtront à la lecture de la description détaillée qui suit des modes de réalisation de l'invention, donnée à titre d'exemple uniquement et en référence aux dessins qui montrent :

- figure 1, une vue schématique d'un variateur de vitesse alimentant un moteur à courant alternatif ;
- figure 2, une vue schématique d'un exemple d'ensemble circuit de commande et circuit de commutation selon l'invention;
- figure 3, un détail de la figure 2 ;
- figure 4, un graphe illustrant la commutation électrique;
- figure 5, un graphique d'illustration d'un avantage du système de la figure 2;
- figure 6, une vue schématique d'un exemple de dispositif selon l'invention;
- figure 7, une vue schématique d'un exemple d'ensemble selon l'invention;
- figures 8 à 14, des vues schématiques d'exemples de système selon l'invention, et
- figure15, un d'ordinogramme d'un exemple de procédé de compensation.

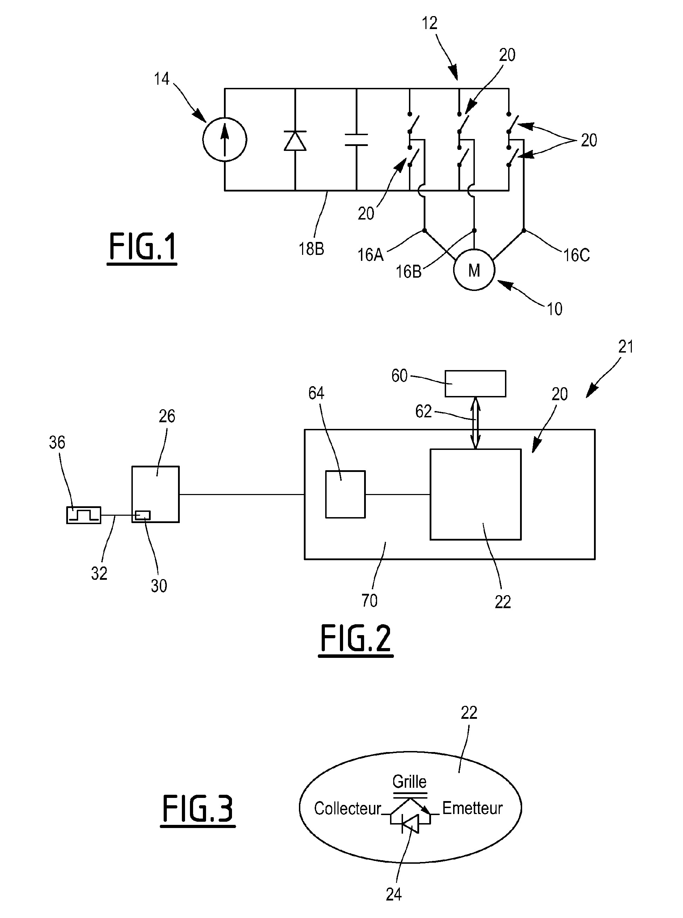

Sur la figure 1, un moteur 10 à courant alternatif est alimenté par une alimentation 12 en tension continue tel qu'illustrée. Ce variateur est relié sur un bus 14 d'alimentation en courant continu. Par exemple, trois pôles 16a, 16b, 16c du moteur sont reliés chacun à une borne 18a, 18b du bus d'alimentation en courant continu par un circuit de commutation 20. Ainsi six circuits de commutation 20 sont mis en oeuvre, chacun entre une phase du moteur et une borne du bus. Chaque circuit de commutation 20 est piloté par un circuit de commande non représenté.

La figure 2 est une vue schématique d'un système 21 comportant un ensemble circuit de commande avec circuit de commutation selon l'invention. Le circuit de commutation 20 dans la figure 2 comporte un transistor 22 de puissance. Dans le cas de cet exemple, le transistor 22 est de type IGBT. Ce transistor 22 est représenté plus en détail dans la vue schématique de la figure 3. De manière connue en soi, le transistor 22 comporte un collecteur, une grille et un émetteur. En outre, entre le collecteur et l'émetteur du transistor 22 se trouve une diode 24 câblée en inverse. Ce transistor IGBT 22 est relié au circuit de commande 26 (parfois appelé par le nom anglais driver). Le circuit de commande 26 comporte plusieurs éléments : il comprend notamment un récepteur optique 30. Ce récepteur 30 reçoit un signal optique transmis par une fibre optique 32 qui est représentatif d'un signal de commande. Dans cet exemple, le signal de commande est émis par un générateur 36 émettant des créneaux avec une tension créneau ayant une amplitude comprise entre 0 et 5 volts. Un tel générateur 36 est, en effet, un générateur usuel qu'il est facile d'utiliser. La fibre optique 32 permet ainsi d'isoler la partie haute tension de la partie basse tension et d'isoler les différents éléments entre eux. Le système 21 comporte également un support de données 60 comprenant des données relatives à la tolérance de fabrication d'au moins un paramètre électrique du transistor 22. De manière schématique, l'interaction existant entre le support de données 60 et le transistor 22 est illustrée par une double flèche 62 sur la figure 2. Selon les modes de réalisation, le support de données 60 est différent. A titre d'exemple, le support de données 60 est une simple feuille qui est fournie par le fournisseur du transistor de puissance 22. Dans un autre cas, la base de données du fournisseur est le support de données 60, ce qui signifie que le support de données 60 est une base de données virtuelle accessible via internet. Alternativement, le support de données 60 est l'enveloppe du transistor de puissance 22 sur laquelle sont inscrites les tolérances de fabrication. D'autres moyens rendant accessibles la tolérance de fabrication pour le transistor de puissance 22 considéré sont envisageables pour le support de données 60.

Les données elles-mêmes ont différentes formes et se présentent de différentes manières selon les cas. Ainsi, lorsque les données sont relatives à un intervalle de tolérance, cet intervalle s'exprime de manière différente selon les cas. A titre d'exemple, si la grandeur G est considérée, l'intervalle de tolérance s'exprime sous la forme plus ou moins 4% ou encore sous la forme $G_{min}$ à $G_{max}$. En outre, selon les modes de réalisation, les données comportent aussi une valeur typique de G.

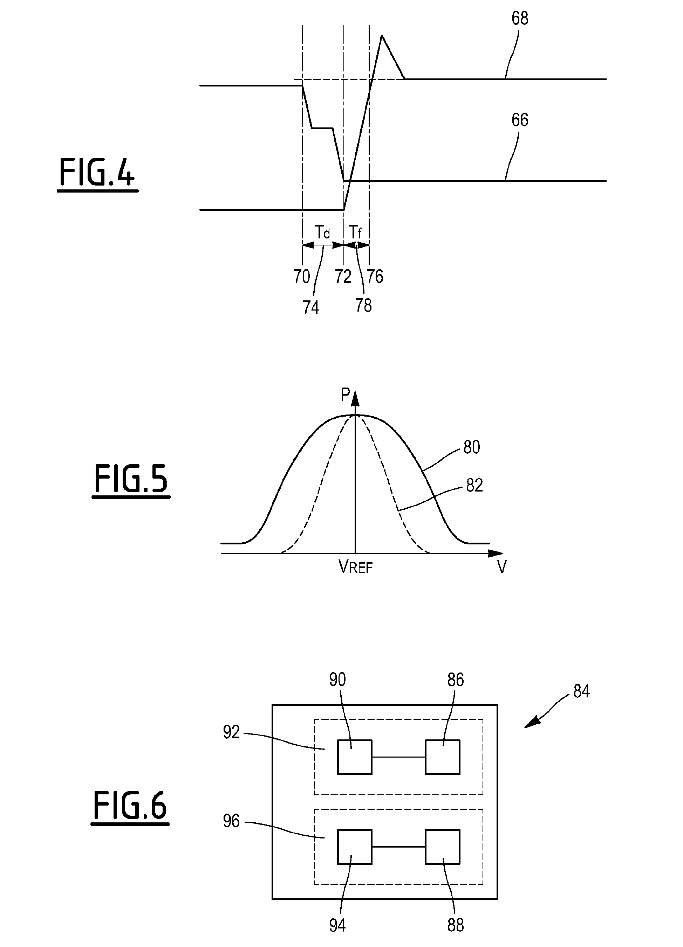

Les paramètres électriques du transistor 22 considéré sont différents selon les variantes. A titre d'exemple, la tension de commande de la grille notée généralement $U_{GE}$ ou encore la tension collecteur/émetteur sont envisageables. Préférentiellement dans le cadre de cette invention, les paramètres électriques considérés sont relatifs à la commutation. Ils influent directement sur la commutation, que ce soit sur le temps de retard (aussi appelé delay time en anglais) ou sur la rapidité de commutation elle-même. Le temps de retard et la rapidité de la commutation sont les deux phénomènes physiques qui caractérisent la commutation d'un circuit de commutation. Le graphe de la figure 4 permet de comprendre la différence entre ces deux phénomènes. Sur cette figure 4, sont représentées deux courbes, la courbe 66 correspondant à la tension de commande de la grille de transistor 22 et la courbe 68 à la tension collecteur/ émetteur de ce transistor 22. Il est observé que pour une consigne de type créneau donné l'instant 70 matérialisée par le trait vertical en traits mixtes, le transistor 22 ne réagit pas immédiatement en se reportant à la tension de commande de la grille. Il y a un retard jusqu'à l'instant 72 illustré par le trait vertical en trait mixtes. Sur la figure 4, ce retard est matérialisé par la double flèche 74 entre les deux traits verticaux 70 et 72. Lors de ce retard, aucune tension n'est mesurée entre le collecteur et l'émetteur. Le temps caractéristique associé est $T_D$. Selon l'exemple de la figure 4, il correspond au temps écoulé entres les instants 72 et 70. Par contre, dans l'intervalle entre les instants verticaux 72 et 76, la tension mesurée entre le collecteur et l'émetteur augmente progressivement jusqu'à atteindre une valeur de tension correspondant à sa valeur en régime stabilisé. Il apparaît ainsi, un temps $T_F$ qui correspond au temps de montée propre du transistor 22. Le temps $T_F$ correspond au temps écoulé entre les instants 72 et 76. Ceci est indiqué par la double flèche 78. La commutation du transistor 22 est donc caractérisée par les paramètres $T_D$ et $T_F$.

Tout paramètre électrique permettant de modifier ou de contrôler ces deux temps $T_D$ et $T_F$ est préférentiellement considéré ici. La modification de ces temps peut notamment se faire par ajustement de la commande du transistor (22) par adaptation d'une valeur de résistance, par variation du courant issu d'un régulateur de courant ou encore par intégration d'un retard à la commande.

Le système 21 de la figure 2 comporte également un circuit de commande 26 du transistor 22 qui est adapté à fonctionner pour une valeur de référence du paramètre choisi.

Un circuit électrique 64 fait également partie du système 21. Ce circuit électrique 64 est conçu de telle manière que l'ensemble 70 formé par le circuit 64 et le transistor 22 a une valeur pour le paramètre considéré dont l'écart en valeur absolue avec la valeur de référence est strictement inférieur à la tolérance de fabrication. Mathématiquement, cela signifie que $|V-V_{REF}| <$ Tol. Où

- V est la valeur du paramètre pour l'ensemble 70 du circuit 64 et du transistor 22,
- $V_{REF}$ est la valeur de référence du paramètre et
- Tol est la valeur de la tolérance de fabrication.

Le circuit électrique 64 présente une inductance maîtrisée. Cela signifie que son inductance est inférieure à celle d'un fil électrique qui connecterait le transistor 22 au dispositif de commande 26. Ainsi, l'inductance du circuit électrique 64 est inférieure à 100 nH, préférentiellement 75 nH.

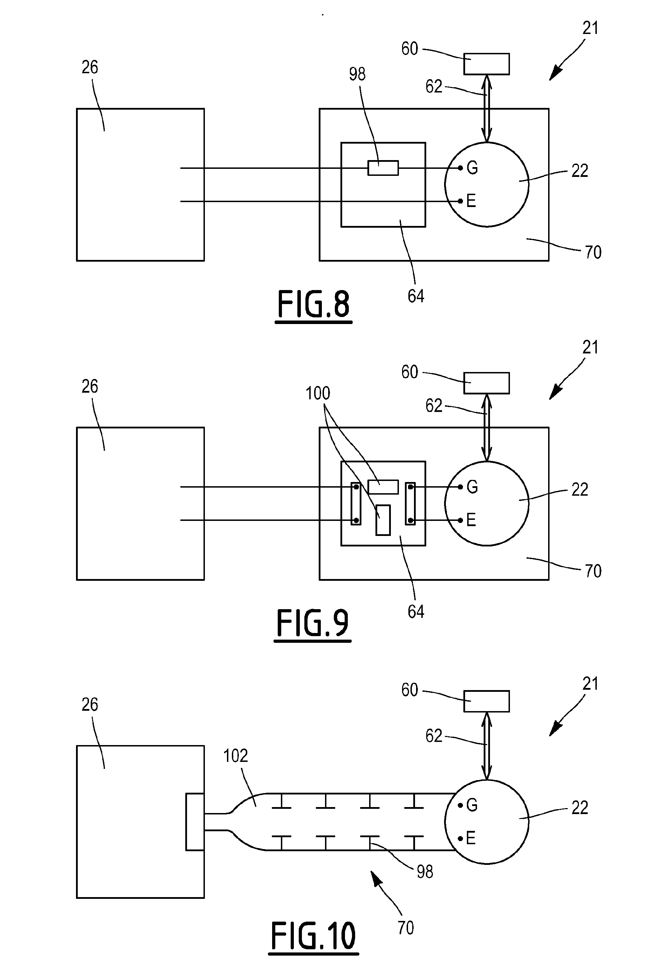

L'intérêt de ce montage 21 est schématiquement illustré par la figure 5. Sur cette figure 10, sont schématisées deux courbes gaussiennes, la gaussienne 80 et la gaussienne de la courbe 82 représentatives de la probabilité de trouver un transistor 22, respectivement un ensemble 70 ayant une valeur V donnée. La largeur à mi-hauteur de la gaussienne 80 est inférieure à la largeur à mi-hauteur de la gaussienne 82. Le transistor 22 présente des tolérances de fabrication correspondant à la largeur à mi-hauteur de la courbe 80. L'intérêt du circuit 64 est de réduire l'élargissement de cette courbe gaussienne 80, ce qui fait que virtuellement l'ensemble 70 est comme un transistor 22 dont les tolérances de fabrication sont plus faibles. Autrement dit, l'ensemble 70 est un transistor 22 avec une dispersion réduite des paramètres de commutation. Le circuit 64 joue ainsi le rôle de circuit réducteur de la dispersion de fabrication des caractéristiques de commutation du composant 22.

Une manière alternative et équivalente de concevoir cette invention est de considérer le dispositif 84 schématisé à la figure 6. Le dispositif 84 comporte un premier transistor 86 de puissance. Ce transistor 86 est un transistor IGBT obtenu par un procédé de fabrication. Il présente une première valeur V1 pour un paramètre électrique donné. Ce paramètre électrique concerne préférentiellement la commutation ainsi que décrit précédemment. Pour la suite, ce paramètre est noté P. Le dispositif 84 comporte également un deuxième transistor 88. Ce deuxième transistor 88 de puissance est également un transistor IGBT qui a été obtenu par le même procédé de fabrication que le premier transistor de puissance 86. Cela signifie qu'il existe des tolérances de fabrication pour le paramètre P entre les deux transistors 86 et 88. Ce deuxième transistor 88 présente une deuxième valeur V2 pour le paramètre P. La deuxième valeur V2 est différente de la première valeur V1. Dans le cas le plus extrême, la différence entre V2 et V1 correspond à la tolérance de fabrication.

Le dispositif 84 comporte également un premier circuit électrique 90 tel que le premier ensemble 92 formé par le premier circuit 86 et le premier transistor 90 présente une troisième valeur V3 pour le paramètre P. Le premier ensemble 92 se forme en liant le premier circuit 90 et le premier transistor 86. Le dispositif 84 comporte en outre un deuxième circuit électrique 94 tel que le deuxième ensemble 96 formé par le deuxième circuit 94 et le deuxième transistor 88 présente une quatrième valeur V4 pour le paramètre P. L'écart en valeur absolue entre la troisième valeur V3 et la quatrième valeur V4 est strictement inférieur à l'écart en valeur absolue entre la première valeur V1 et la deuxième valeur V2. Cela se traduit mathématiquement par l'inégalité :

$$|V3-V4| < |V1-V2|.$$

Chacun des circuits électriques 90 et 94 présente une inductance maîtrisée. Le circuit électrique 90, respectivement circuit électrique 94, présente une inductance maîtrisée. Cela signifie que son inductance est inférieure à celle d'un fil électrique qui connecterait le transistor 22 au dispositif de commande 26. Ainsi, l'inductance du circuit électrique 90, respectivement circuit électrique 94, est inférieure à 100 nH (nanoHenry), préférentiellement 75 nH.

Ici encore, l'avantage de réduire les tolérances de fabrication est assuré par l'adjonction des circuits électriques 90 et 94.

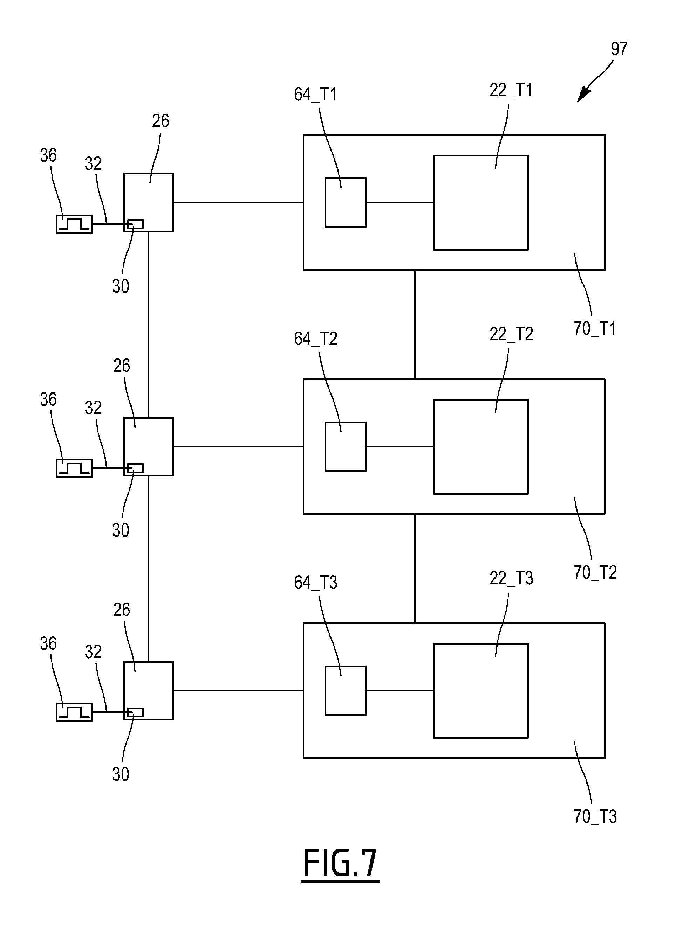

Obtenir des dispersions réduites pour les paramètres de commutation du circuit de commutation permet l'utilisation d'un circuit de commande 26 qui serait standard. Cela est illustré par la figure 7 qui présente un ensemble 97 avec trois transistors T1, T2 et T3 qui sont commandés par un circuit de commande 26 identique. Pour illustrer cela, il a été choisi d'utiliser les mêmes signes de références que dans la figure 2 en les faisant suivre d'une indication - Ti pour montrer qu'il s'agit de l'élément dédié pour le transistor Ti. Ainsi, les circuits 64-T1, 64-T2 et 64-T3 sont spécifiques du transistor considéré alors que les circuits de commande 26 sont les mêmes quel que soit l'ensemble 70-Ti considéré. Outre l'avantage impliquant de ne pas avoir à fabriquer des circuits de commande 26 personnalisés, l'emploi de l'ensemble 97 permet surtout de faciliter la maintenance des systèmes comportant des transistors IGBT. En effet, en cas de défaillance d'un élément défectueux, qu'il s'agisse du transistor IGBT lui-même ou du circuit de commande, le remplacement de l'élément défectueux n'implique pas de nouveaux tests pour réappairer l'ensemble du circuit de commutation et du circuit de commande.

Nous allons maintenant illustrer quelques modes de réalisation différents de cette idée en mettant en évidence les avantages qui leur sont associés. Ceci nous amènera à décrire avec plus de précisions les éléments qui sont contenus dans le circuit 64 de la figure 2.

A titre de premier exemple de réalisation, le mode de réalisation de la figure 8 peut être considéré. Les mêmes signes de référence que ceux de la figure 2 lorsque c'est pertinent sont répétés. Selon l'exemple de la figure8, le circuit 64 comporte des éléments passifs. L'élément passif est une résistance 98 traversante dans ce cas. L'utilisation d'une résistance a l'avantage d'être particulièrement simple à mettre en oeuvre.

La figure 9 illustre un autre exemple de système 21 avec un circuit 64 électrique différent. Dans ce cas, le circuit électrique 64 est un circuit imprimé rigide sur lequel des composants 100 sont soudés. Les composants 100 sont, de même que, pour le cas de la figure 8, des éléments passifs comme une résistance ou sont des éléments actifs. A titre d'exemple d'éléments actifs, une source de courant dont le courant est différent en fonction des caractéristiques du transistor IGBT 22 pour obtenir toujours la même valeur pour la somme des intervalles de temps $T_D$ et $T_F$ est envisageable. Dans les deux cas qui viennent d'être décrits, à savoir ceux des figures 8 et 9, les deux ensembles 70 présentent les avantages précédemment décrits.

La figure 10 illustre un autre mode de réalisation particulièrement avantageux. Selon ce mode de réalisation, le circuit 64 est un circuit souple 102 ayant l'avantage d'avoir une inductance inférieure à un câble et reproductible. Selon les cas, le circuit souple 102 intègre des composants assurant l'ajustement. Les composants sont soit passifs soit actifs. A titre d'exemple, les composants 98 envisagés sont les mêmes que les composants 98 décrits en référence à la figure 8. Selon un mode de réalisation, la liaison par circuit souple 102 supporte une connectique permettant de porter un circuit imprimé de petite taille. De préférence, cette connectique est une connectique standardisée.

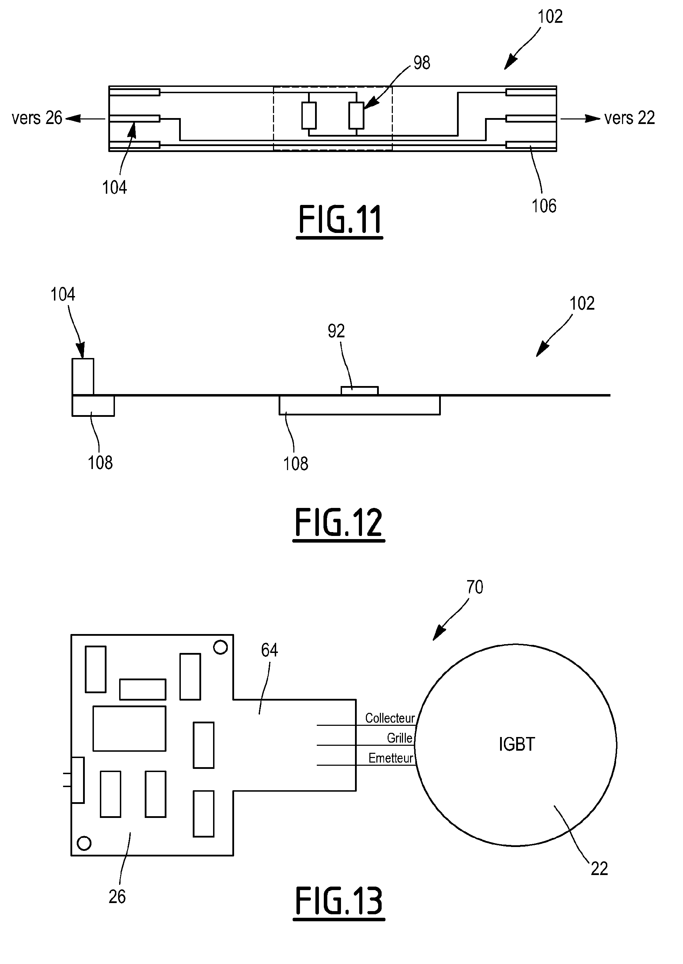

L'avantage d'utiliser un circuit souple 102 est un avantage géométrique. En effet, un circuit souple est déformable contrairement à un circuit imprimé rigide comme dans le cas de la figure 9. Dans le cas de transistors de puissance comme les transistors IGBT, de nombreuses contraintes mécaniques sont imposées aux connexions. De ce fait, bénéficier d'une liaison avec une flexibilité accrue est particulièrement favorable. En effet, un circuit souple 102 peut être déformé à loisir ce qui permet d'envisager des configurations tridimensionnelles qu'il serait très difficile de réaliser avec un circuit imprimé rigide. De surcroît, cette configuration est modifiable selon les souhaits de l'utilisateur. Les figures 11 et 12 illustrent le circuit connexion souple 102. Selon la figure 11, le circuit souple 102 est vu de dessus. Sur la gauche, des connexions 104 vers le circuit de commande 26 sont représentées. Les connexions 104 sont par exemple des connecteurs montés en surfaces (connecteurs CMS) ou des plages de cuivre. Le circuit souple 102 comporte également en son centre des composants 98. Le circuit souple 104 comporte aussi des connexions 106 vers le transistor IGBT 22. Ces connexions 106 sont au nombre de trois pour les trois voies du transistor IGBT 22 à savoir le collecteur, la grille et l'émetteur. Les connexions 100 sont à titre d'exemple des plages de cuivre ou un contact à souder. La figure 12 est une vue schématique latérale du circuit souple 102. Les composants 98 et les connecteurs 104 sont communs avec la figure 11. Sont en outre représentés les supports 108 qui permettent de rigidifier le circuit souple 104 dans les zones supportant les composants. Ces supports sont par exemple en matériaux de type FR4, en matériau CEM1, en aluminium ou autre. Les matériaux de type FR4 (abréviation de l'anglais Flame Resistant 4) sont des composites de résine époxy renforcée de fibre de verre alors que les matériaux de type CEM1 sont des matériaux composites de résine époxy avec de la fibre de verre et un coeur en papier.

Selon un autre mode de réalisation illustré par la figure 13, le circuit électrique 64 et le circuit de commande 26 sont confondus. Cela permet une intégration totale des circuits de commande avec le transistor IGBT 22, l'ensemble 70 est alors directement connectable à la source d'alimentation. Il en résulte une manipulation plus aisée des transistors IGBT 22. Le circuit électrique 64 sera ainsi directement ajusté au transistor IGBT 22. Ceci est mis en oeuvre par exemple à l'aide d'une liaison série externe pour ajuster la commande du transistor IGBT 22 selon la figure13.

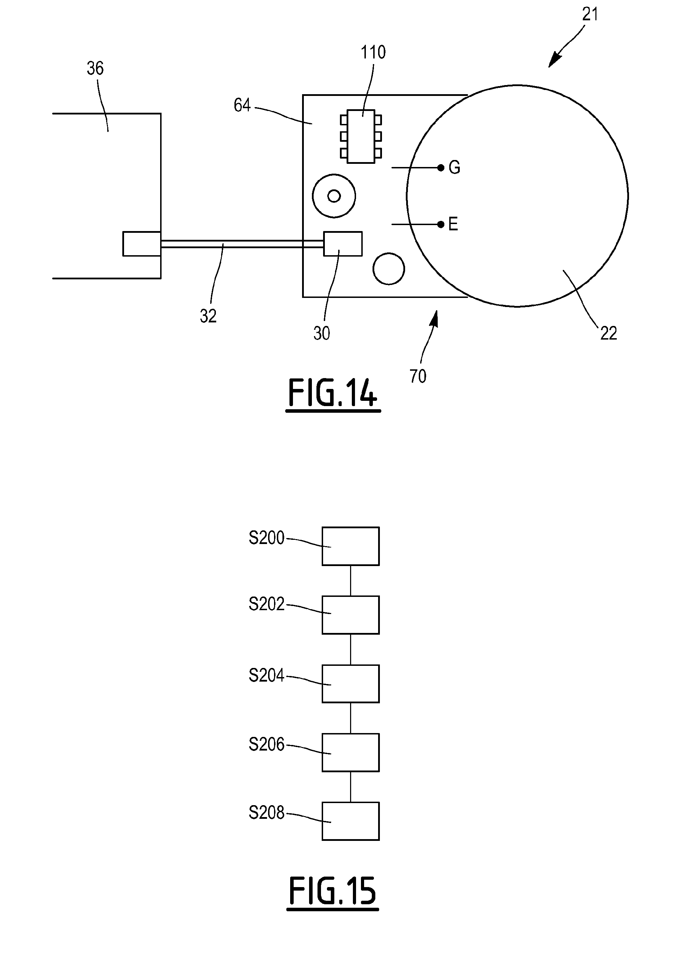

La figure 14 montre un autre exemple de réalisation d'un circuit de commande intégré avec le transistor IGBT 22. Dans ce cas, il est envisagé un circuit intégré spécifique appelé ASIC. Un ASIC (acronyme de l'anglais Application-Specific Integrated Circuit, qui signifie littéralement « Circuit intégré propre à une application ») est un circuit intégré spécialisé regroupant généralement un grand nombre de fonctionnalités uniques et/ou sur mesure. L'intérêt de l'intégration est de réduire les coûts de production et d'augmenter la fiabilité tout en permettant une intégration importante. Aujourd'hui, un circuit électronique numérique est développé en utilisant un langage de description (type VHDL) qui est compilé par synthèse logique pour produire automatiquement le dessin du circuit. Les mêmes langages de description sont utilisés pour réaliser des prototypes et des préséries avec des composants logiques programmables ou FPGA. En raison du coût initial important, la production d'ASIC est néanmoins réservée généralement à de gros volumes. Dans le cas présent, ces ASIC 110 seront tels qu'ils permettront d'ajuster artificiellement l'intervalle de temps $T_D$ à partir de compteurs pour réduire ou augmenter la valeur de l'intervalle de temps $T_D$ pour garantir que la valeur totale de la somme des intervalles de temps $T_D$ et $T_F$ soit toujours la même au cours du temps.

De manière préférentielle, un tel circuit de commande 64 intégré dispose d'une liaison 32 vers le contrôle 36 pour communiquer différentes informations et permettre également d'ajuster la valeur du temps $T_D$.

Il a donc été décrit des systèmes 21 avec un circuit électrique 64 permettant de réduire les tolérances de fabrication perçues lorsque l'ensemble 70 formé par le circuit 64 lui-même avec le transistor 22 est considéré. A terme, ceci permet d'envisager la production d'ensemble 70 standardisé formé par un circuit électrique 64 et le transistor IGBT 22 associé. Cela devrait permettre d'envisager la réalisation de connexion en série d'un nombre potentiellement illimité de transistors IGBT. En effet, avec un composant standardisé, la synchronisation est grandement facilitée.

Selon l'invention, il est également proposé un procédé permettant de choisir les caractéristiques du circuit électrique pour que l'ensemble 70 formé ait les caractéristiques voulues.

Ce procédé est illustré par l'organigramme de la Figure15. Ce procédé est un procédé de compensation de tolérances de fabrication Tol_i d'au moins un paramètre électrique du transistor de puissance 22. Ce procédé comporte une étape S200 de fourniture d'un transistor de puissance 22. Ce transistor est préférentiellement un transistor de type IGBT 22. Ce procédé comporte également une étape S202 fourniture de données relatives à la tolérance de fabrication Tol d'au moins un paramètre électrique du transistor 22. Selon les cas, les données sont fournies de différentes manières : par un accès à une base de données internet du fabricant, fourniture d'une simple feuille de papier donnant les indications ou tout autre moyen.

Le procédé comporte également une étape S204 de fournitures d'une valeur de référence $V_{REF}$ pour le paramètre. Cette étape S204 de fournitures est par exemple réalisée par la fourniture d'un circuit de commande 26 donnant par ses caractéristiques la valeur de référence $V_{REF}$. En effet, la valeur de référence $V_{REF}$ correspondra à la valeur pour laquelle le circuit de commande 26 est adaptée à fonctionner. Cette valeur $V_{REF}$ est indiquée sur le circuit lui-même ou est fournie au moyen d'une base de données ou d'une notice donnée par le fabricant.

Le procédé comporte aussi une étape S206 de choix des caractéristiques du circuit électrique 70 tel que l'ensemble 70 formé par le circuit 64 et le transistor 22 présente une valeur pour le paramètre dont l'écart en valeur absolue avec la valeur de référence est strictement inférieur à la tolérance de fabrication. Autrement formulé, Tol_i qui est la tolérance cible est inférieure à la tolérance initiale notée Tol. Le circuit électrique 70 présente en outre une inductance maîtrisée, soit une inductance inférieure à 100 nH, préférentiellement inférieure à 75 nH.

A cette étape S206, les différentes structures précédemment présentées en référence aux Figures 8 à 14 sont envisageables et les paramètres des différents éléments de ces circuits seront les caractéristiques qui seront recherchées. A titre d'exemple, nous allons considérer le cas de la Figure 8 où le composant 98 est simplement une résistance. Dans ce cas, la seule caractéristique à connaître est la valeur de la résistance et l'inductance du circuit 64.

Le procédé comporte alors une étape S108 d'ajustement. Cet ajustement est mis en oeuvre de différentes manières selon les variantes considérées. Cet ajustement de la valeur de la résistance est fait par suppression de la connexion électrique assurant la mise en parallèle de plusieurs résistances. Cet ajustement présente l'avantage d'être facile à mettre en oeuvre mais, néanmoins, il ne permet qu'un ajustement avec des valeurs discrètes. Il est envisageable de faire un meilleur ajustement à l'aide d'un laser. Le laser est alors destiné à faire une insolation d'une partie de la résistance ce qui permet de varier la résistance. Cette technique est appelée « trim laser ».

Il a été ainsi décrit en référence à la Figure 15 un procédé de compensation de tolérance de fabrication d'au moins un paramètre électrique d'un transistor de puissance permettant d'obtenir un ensemble 70 formé par le circuit électrique 64 et le transistor 22 ayant les caractéristiques désirées dans le cadre de cette invention. Ce procédé étant facile à mettre en oeuvre, il devrait permettre de grandement faciliter la mise en série des transistors IGBT 22 à terme.

**Revendications**

1. Dispositif (84) comportant :

- un premier transistor de puissance (86) obtenu par un procédé de fabrication et présentant une première valeur (V1) pour un paramètre électrique (P) du transistor (86),
- un deuxième transistor de puissance (88) obtenu par le même procédé de fabrication présentant une deuxième valeur (V2) pour le paramètre (P), la deuxième valeur (V2) étant différente de la première valeur (V1),
- un premier circuit électrique (90) tel que le premier ensemble (96) formé par le premier circuit électrique (90) et le premier transistor (86) présente une troisième valeur (V3) pour le paramètre (P), et
- un deuxième circuit électrique (94) tel que le deuxième ensemble (92) formé par le deuxième circuit électrique (94) et le deuxième transistor (88) présente une quatrième valeur (V4) pour le paramètre (P),

le dispositif (84) étant **caractérisé en ce que** l'écart en valeur absolue entre la troisième valeur (V3) et la quatrième valeur (V4) est strictement inférieur à l'écart en valeur absolue entre la première valeur (V1) et la deuxième valeur (V2) et **en ce que** :

- le premier circuit électrique (90) :

  ○ présente une inductance inférieure à 100 nH,
  ○ est un circuit souple, et
  ○ comporte des composants passifs (98) ou actifs,

- le deuxième circuit électrique (94) :

  ○ présente une inductance inférieure à 100 nH,
  ○ est un circuit souple, et
  ○ comporte des composants passifs (98) ou actifs.

2. Dispositif selon la revendication 1, dans lequel le paramètre électrique (P) est relatif à la commutation des transistors (86, 88).

3. Dispositif selon la revendication 1 ou 2, dans lequel le paramètre électrique (P) est l'un des paramètres suivants : la capacité Miller, la tension de seuil des transistors (86, 88), le temps de retard ($T_D$) des transistors (86, 88) et le temps de montée ($T_F$) des transistors (86, 88).

4. Dispositif selon l'une quelconque des revendications 1 à 3, dans lequel au moins l'un du premier circuit électrique (90) et du deuxième circuit électrique (94) présente une inductance inférieure à 75 nH.

5. Système (21) comportant :

- un transistor de puissance (22),
- un support de données (60) comprenant des données relatives à la tolérance de fabrication (Tol) d'au moins un paramètre (P) électrique du transistor (22), et
- un circuit électrique de commande (26) du transistor (22) adapté à fonctionner pour une valeur de référence du paramètre ($V_{REF}$),

le système (21) étant **caractérisé en ce que** le système (21) comporte, en outre, un circuit électrique (64) :

- présentant une inductance inférieure à 100 nH,
- étant un circuit souple,
- comportant des composants passifs (98) ou actifs, et
- tel que l'ensemble (70) formé par le circuit électrique (64) et le transistor (22) a une valeur pour le paramètre (P) électrique dont l'écart en valeur absolue avec la valeur de référence ($V_{REF}$) est strictement inférieur à la tolérance de fabrication (Tol).

6. Système selon la revendication 5, dans laquelle le support de données (60) est une notice du transistor (22).

7. Système selon la revendication 5 ou 6, dans lequel le circuit électrique (64) et le circuit électrique de commande (26) sont confondus.

8. Système selon l'une quelconque des revendications 5 à 7, dans lequel le paramètre électrique (P) est relatif à la commutation du transistor (22).

9. Système selon l'une quelconque des revendications 5 à 8, dans lequel le paramètre électrique (P) est l'un des paramètres suivants : la capacité Miller, la tension de seuil du transistor (22), le temps de retard ($T_D$) du transistor (22) et le temps de montée ($T_F$) du transistor (22).

10. Système selon l'une quelconque des revendications 5 à 9, dans lequel le circuit électrique (64) présente une inductance inférieure à 75 nH.

11. Système selon l'une quelconque des revendications 5 à 10, le systéme (21). étant destiné au déclenchement simultané de transistors de puissance

12. Ensemble comportant plusieurs systèmes (21) selon l'une quelconque des revendications 5 à 11, les circuits électriques de commande (26) étant les mêmes pour chaque transistor (22) des systèmes (21).

13. Alimentation électrique comportant l'ensemble de la revendication 12.

14. Procédé de compensation de tolérances de fabrication (Tol_i) d'au moins un paramètre électrique (P) d'un transistor de puissance (22), le procédé comportant les étapes de :

    - fourniture d'un transistor de puissance (22),
    - fourniture de données relatives à la tolérance de fabrication (Tol) d'au moins un paramètre électrique (P) du transistor (22),
    - fourniture d'une valeur de référence ($V_{ref}$) pour le paramètre électrique (P),
    - fourniture d'un circuit électrique (64)

        ○ présentant une inductance inférieure à 100 nH,
        ○ étant un circuit souple,
        ○ comportant des composants passifs (98) ou actifs, et
        ○ tel que l'ensemble (70) formé par le circuit électrique (64) et le transistor (22) a une valeur pour le paramètre (P) dont l'écart en valeur absolue avec la valeur de référence ($V_{REF}$) est strictement inférieur à la tolérance de fabrication (Tol).

FIG.1

FIG.2

FIG.3

FIG.4

68

66

$T_d$ $T_f$

70 72 76

74 78

FIG.5

P

80

82

$V_{REF}$

V

FIG.6

90 86

84

92

96

94 88

FIG.7

FIG.8

FIG.9

FIG.10

vers 26 ←   → vers 22

FIG.11

FIG.12

Collecteur
Grille
Emetteur

IGBT

FIG.13

FIG.14

FIG.15

EP 2 639 960 A1

Europäisches Patentamt

European Patent Office

Office européen des brevets

**RAPPORT DE RECHERCHE EUROPEENNE**

Numéro de la demande

EP 13 15 9545

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 5 492 842 A (EYTCHESON CHARLES T [US] ET AL) 20 février 1996 (1996-02-20) <br> * figures 6-13 * <br> * colonne 8, ligne 50 - colonne 9, ligne 7 * <br> * colonne 13, ligne 50 - ligne 62 * <br> ----- | 1-5,7,8, 10-14 | INV. <br> H03K17/10 <br> H03K17/14 <br> H02M7/00 <br> H02M1/088 |
| X | US 2010/148847 A1 (SCHURACK JOHANNES [DE] ET AL) 17 juin 2010 (2010-06-17) <br> * figure 1 * <br> ----- | 1,2,4-7, 9-14 | |
| | | | **DOMAINES TECHNIQUES RECHERCHES (IPC)** |
| | | | H03K <br> H02M <br> H01L <br> H01C |

Le présent rapport a été établi pour toutes les revendications

| Lieu de la recherche | Date d'achèvement de la recherche | Examinateur |
|---|---|---|
| La Haye | 6 juin 2013 | Loiseau, Ludovic |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

16

**ANNEXE AU RAPPORT DE RECHERCHE EUROPEENNE
RELATIF A LA DEMANDE DE BREVET EUROPEEN NO.**
EP 13 15 9545

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-06-2013

| Document brevet cité au rapport de recherche | | Date de publication | Membre(s) de la famille de brevet(s) | | Date de publication |
|---|---|---|---|---|---|
| US 5492842 | A | 20-02-1996 | US | 5492842 A | 20-02-1996 |
| | | | US | 5539254 A | 23-07-1996 |
| US 2010148847 | A1 | 17-06-2010 | AT | 472854 T | 15-07-2010 |
| | | | DE | 102006024938 B3 | 30-08-2007 |
| | | | EP | 2020082 A2 | 04-02-2009 |
| | | | US | 2010148847 A1 | 17-06-2010 |
| | | | WO | 2007134589 A2 | 29-11-2007 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0458511 A
- DE 1413526 A
- WO 2007122322 A